# FASCICULE DE BREVET EUROPEEN

(11) **EP 3 188 234 B1**
(45) Date de publication et mention de la délivrance du brevet: **21.10.2020**
(21) Numéro de dépôt: 16166144.2
(22) Date de dépôt: 20.04.2016
(51) Int. Cl.: H01L 27/06, H01L 27/11546, H01L 29/66, H01L 21/28, H01L 49/02, H01L 29/49, H01L 21/8234, H01L 27/11541

(54) **CIRCUIT INTÉGRÉ ET SON PROCÉDÉ DE FABRICATION**
INTEGRIERTER SCHALTKREIS UND SEIN HERSTELLUNGSVERFAHREN
INTEGRATED CIRCUIT AND METHOD FOR MANUFACTURING SAME

(30) Priorité: 29.12.2015 FR 1563435
(43) Date de publication de la demande: 05.07.2017
(73) Titulaire: STMicroelectronics (Crolles 2) SAS, 38920 Crolles (FR)
(72) Inventeur: PIAZZA, Fausto, 38000 GRENOBLE (FR); LAGRASTA, Sebastien, 38660 LA TERRASSE (FR); BIANCHI, Raul Andres, 73800 MYANS (FR); JEANNOT, Simon, 38000 GRENOBLE (FR)
(74) Mandataire: Cabinet Beaumont

(56) Documents cités:
- US-A1- 2006 030 112
- US-A1- 2006 134 874
- US-A1- 2010 032 741
- US-A1- 2010 155 852
- US-A1- 2011 062 507
- US-A1- 2011 095 348
- US-A1- 2014 024 183

## Description

### Domaine

La présente demande concerne un circuit intégré et son procédé de fabrication, le circuit intégré comprenant des transistors MOS de types différents et au moins un condensateur.

### Exposé de l'art antérieur

Dans un circuit intégré, des transistors MOS de types différents sont couramment utilisés, par exemple des transistors MOS destinés à fonctionner à des tensions élevées, ou transistors HV, des transistors MOS destinés à fonctionner à des tensions plus faibles, ou transistors LV, et des transistors MOS à grille flottante, ou transistors NVM, constituant des mémoires non volatiles. L'empilement de grille d'un transistor NVM comprend, sur un isolant de grille, une électrode de grille, dite "grille flottante", surmontée d'une autre électrode de grille, dite "grille de commande", isolée électriquement de la grille flottante. Généralement, un tel circuit intégré comprend également au moins un condensateur CAPA pour générer des tensions élevées susceptibles d'être appliquées à la grille de commande, au drain ou à la source des transistors NVM. Les documents US 2011/095348 et US 2010/03271 décrivent des exemples de circuits intégrés.

Dans le cas d'un circuit intégré comprenant des transistors MOS de différents types, le nombre et/ou l'épaisseur des espaceurs bordant l'empilement de grille de chaque type de transistor devraient être choisis en fonction des tensions susceptibles d'être appliquées à ce type de transistor.

Il serait donc souhaitable de disposer d'un procédé de fabrication d'un circuit intégré comprenant des transistors MOS de types différents associés à différents espaceurs. Il serait également souhaitable que ce procédé de fabrication permette de réaliser un condensateur adapté à fournir des tensions élevées.

### Résumé

Ainsi, l'invention prévoit un procédé selon la revendication 1 et un circuit intégré selon la revendication 4. Des modes de réalisation sont définis dans les revendications 2, 3, 5 et 6.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1G illustrent une structure à des étapes successives d'un exemple de procédé de fabrication d'un circuit intégré ; et
les figures 2A à 2E illustrent une structure à des étapes successives d'un mode de réalisation d'un procédé de fabrication d'un circuit intégré.

### Description détaillée

De mêmes éléments ont été désignés par de mêmes références dans les différentes figures et, de plus, les diverses figures ne sont pas tracées à l'échelle. Par souci de clarté, seuls les éléments qui sont utiles à la compréhension des modes de réalisation décrits ont été représentés et sont détaillés. Dans la description qui suit, les termes "sur" et "sous" se réfèrent à l'orientation des éléments concernés dans les figures correspondantes.

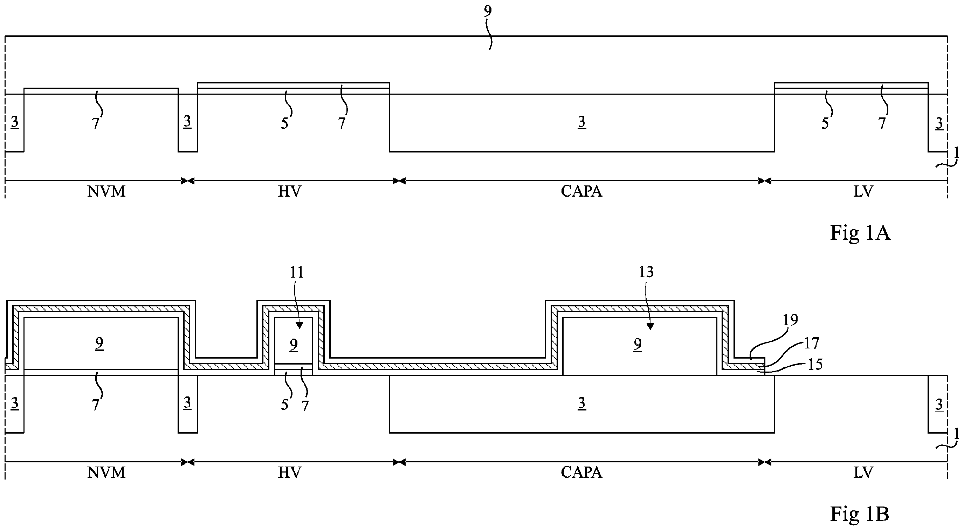

Les figures 1A à 1G sont des vues en coupe schématiques représentant une structure à des étapes successives d'un exemple de procédé de fabrication d'un circuit intégré comprenant divers types de transistors et un condensateur.

En figure 1A, la structure comprend une couche semiconductrice 1, par exemple une couche de silicium, dont une portion seulement est représentée. La portion représentée comprend un emplacement de transistor MOS à grille flottante NVM, un emplacement de transistor MOS haute tension HV, un emplacement de condensateur CAPA, et un emplacement de transistor MOS basse tension LV. Des structures isolantes 3, par exemple des tranchées remplies d'un matériau isolant, ont été formées dans la couche semiconductrice 1 et délimitent les emplacements des transistors NVM, HV et LV, et du condensateur CAPA. Dans cet exemple, l'une des structures isolantes 3 s'étend sous toute la surface de l'emplacement du condensateur CAPA. Une première couche d'isolant de grille 5 a été formée sur la couche semiconductrice 1 à l'emplacement du transistor MOS HV, et une deuxième couche d'isolant de grille 7 a été formée sur la couche semiconductrice 1 à l'emplacement du transistor NVM. Plus particulièrement, dans cet exemple, la première couche isolante 5 a été formée sur toute la surface exposée de la couche semiconductrice 1 puis retirée à l'emplacement du transistor NVM, et la deuxième couche isolante 7 a ensuite été formée sur la couche semiconductrice 1 à l'emplacement du transistor NVM, et sur la couche 5 à l'emplacement des transistors HV et LV. Une couche de silicium polycristallin 9 a alors été déposée sur toute la structure.

A titre d'exemple, la couche 5 est une couche d'oxyde de silicium pouvant avoir une épaisseur comprise entre 5 et 15 nm, par exemple 9 nm. La couche 7 est par exemple une couche d'oxyde de silicium pouvant avoir une épaisseur comprise entre 5 et 10 nm, par exemple 9 nm. L'épaisseur de la couche de silicium polycristallin 9 peut être comprise entre 100 et 150 nm, par exemple 125 nm. Le silicium polycristallin 9 peut être dopé lors d'une étape d'implantation ultérieure à son dépôt, ou in situ lors de son dépôt.

La figure 1B représente la structure de la figure 1A après délimitation de l'empilement de grille 11 du transistor HV et de la première électrode 13 du condensateur CAPA. Pour cela, à l'emplacement du transistor HV, la couche de silicium polycristallin 9 et les couches d'isolant de grille 7 et 5 sont retirées par gravure en laissant en place des portions de ces couches correspondant à l'empilement de grille 11, et, à l'emplacement du condensateur CAPA, la couche de silicium polycristallin 9 est retirée par gravure en laissant en place une portion de cette couche correspondant à l'électrode 13. Les couches 9, 7 et 5 sont également retirées par gravure à l'emplacement du transistor LV, et laissées en place à l'emplacement du transistor NVM. Cette étape de gravure est réalisée simultanément aux emplacements du condensateur CAPA et des transistors HV et LV. L'étape de gravure est suivie de la formation successive, sur toute la structure, d'une couche d'oxyde de silicium 15, d'une couche conforme de nitrure de silicium 17 et d'une couche conforme d'oxyde de silicium 19. Les couches 15, 17 et 19 sont ensuite retirées par gravure à l'emplacement du transistor LV.

A titre d'exemple, l'épaisseur de la couche d'oxyde 15 est comprise entre 3 et 20 nm, par exemple 4 nm. L'épaisseur de la couche de nitrure 17 peut être comprise entre 2 et 5 nm, par exemple 3,5 nm. L'épaisseur de la couche d'oxyde 19 peut être comprise entre 2 et 10 nm, par exemple 4 nm.

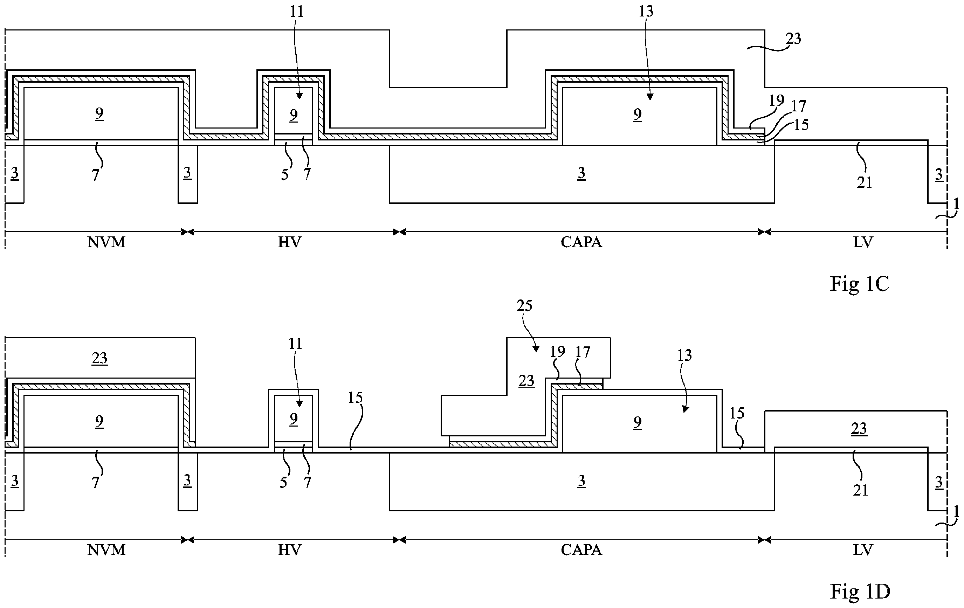

La figure 1C représente la structure de la figure 1B après la formation d'une couche d'isolant de grille 21 à l'emplacement du transistor LV suivie du dépôt d'une couche de silicium polycristallin 23 sur toute la structure.

A titre d'exemple, la couche 21 est une couche d'oxyde de silicium. L'épaisseur de la couche 21 peut être comprise entre 1 et 10 nm, par exemple 2,5 nm. L'épaisseur de la couche de silicium polycristallin 23 peut être comprise entre 60 et 120 nm, par exemple 100 nm. Le silicium polycristallin 23 peut être dopé lors d'une étape d'implantation ultérieure à son dépôt, ou in situ lors de son dépôt.

La figure 1D représente la structure de la figure 1C après délimitation de la deuxième électrode 25 du condensateur CAPA, l'électrode 25 reposant au moins en partie sur l'électrode 13. Pour cela, aux emplacements du condensateur CAPA et du transistor HV, la couche de silicium polycristallin 23 est retirée par gravure en laissant en place une portion de cette couche 23 correspondant à l'électrode 25, la couche 23 étant laissée en place aux emplacements des transistors NVM et LV. La gravure est arrêtée sur la couche de nitrure de silicium 17, d'où il résulte que les portions de la couche d'oxyde de silicium 19 exposées suite à la gravure du silicium polycristallin 23 sont retirées elles aussi. Les portions de la couche de nitrure 17 exposées suite à la gravure de la couche d'oxyde 19 sont alors retirées par gravure isotrope, par exemple par gravure humide.

Comme cela est représenté ici, la gravure isotrope de la couche de nitrure 17 s'étend partiellement sous le silicium polycristallin 23, au niveau des flancs de l'électrode 25, où la couche de nitrure 17 risque d'être surgravée. De plus, lors de la gravure de l'oxyde de silicium 19 et éventuellement de la gravure du nitrure de silicium 17, la couche d'oxyde de silicium 19 risque également d'être surgravée sous les flancs de l'électrode 15.

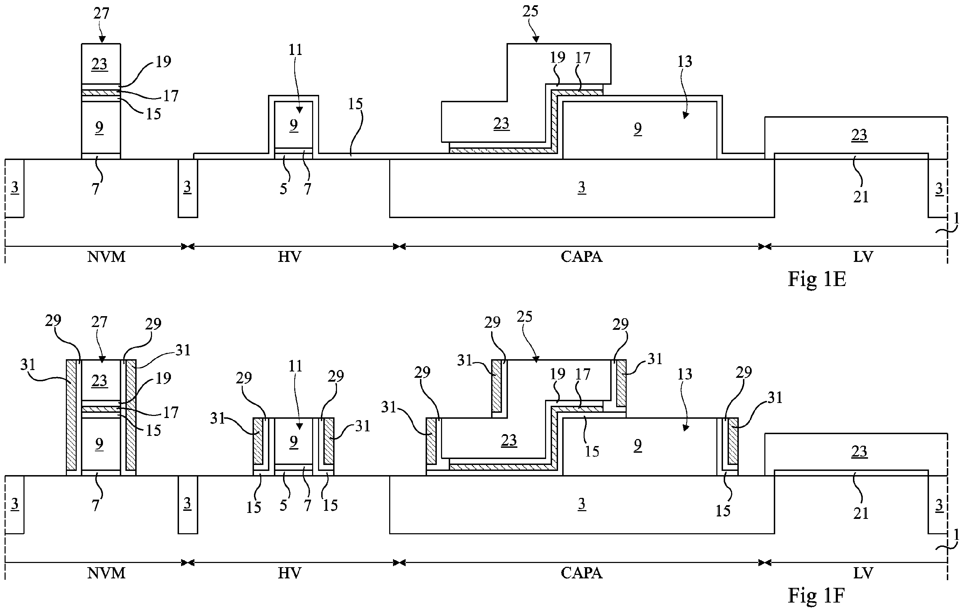

La figure 1E représente la structure de la figure 1D après la formation de l'empilement de grille 27 du transistor NVM. Pour cela, à l'emplacement du transistor NVM, les couches 23, 19, 17, 15, 9 et 7 sont retirées par gravure en laissant en place des portions de ces couches correspondant à l'empilement de grille 27. Pendant cette étape de gravure, les couches 23 et 15 sont laissées en place aux emplacements du condensateur CAPA et des transistors HV et LV.

La figure 1F représente la structure de la figure 1E après la formation d'espaceurs en oxyde de silicium 29 et d'espaceurs en nitrure de silicium 31. Pour cela, une couche d'oxyde de silicium 29 est formée par oxydation thermique au moins aux emplacements du condensateur CAPA et des transistors HV et NVM puis une couche de nitrure de silicium 31 est déposée de façon conforme sur la couche d'oxyde 29. L'oxyde de silicium 29 et le nitrure de silicium 31 sont alors gravés par gravure anisotrope pour former des espaceurs en oxyde de silicium 29 bordant latéralement les empilements de grille 11 et 27 des transistors HV et NVM, et les électrodes 13 et 25 du condensateur CAPA, et pour former des espaceurs en nitrure de silicium 31 bordant latéralement les espaceurs 29.

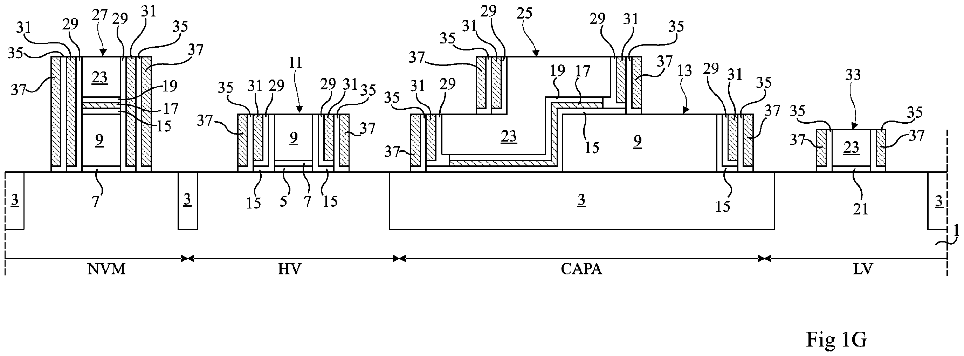

La figure 1G représente la structure de la figure 1F après délimitation de l'empilement de grille 33 du transistor LV suivie de la formation d'espaceurs en oxyde de silicium 35 et d'espaceurs en nitrure de silicium 37. Pour cela, à l'emplacement du transistor LV, la couche de silicium polycristallin 23 et la couche d'isolant de grille 21 sont retirées par gravure en laissant en place des portions de ces couches correspondant à l'empilement de grille 33. Lors de la formation de l'empilement de grille 33, les couches ou les portions de couches déjà formées aux emplacements du condensateur CAPA et des transistors NVM et HV sont laissées en place. Après délimitation de l'empilement de grille 33, une couche d'oxyde de silicium 35 puis une couche de nitrure de silicium 37 sont formées de manière conforme sur toute la structure. L'oxyde de silicium 35 et le nitrure de silicium 37 sont alors gravés par gravure anisotrope pour former des espaceurs en oxyde de silicium 35 et en nitrure de silicium 37 sur les parois verticales de la structure. En particulier, les espaceurs en oxyde de silicium 35 bordent latéralement les empilements de grille 11, 27 et 33 des transistors HV, NVM et LV, et les électrodes 13 et 25 du condensateur CAPA, et sont eux mêmes bordés latéralement par les espaceurs en nitrure de silicium 37.

On obtient ainsi un circuit intégré comprenant un condensateur CAPA et des transistors NVM, HV et LV.

Un inconvénient du procédé de fabrication décrit ci-dessus est que, dans le circuit intégré obtenu, les empilements de grille 27 et 11 des transistors NVM et HV sont bordés par les mêmes espaceurs 29, 31, 35 et 37 alors qu'il serait souhaitable que les empilements de grille 27 des transistors NVM soient bordés d'un ensemble d'espaceurs moins épais que celui bordant les empilements de grille 11 des transistors HV. Des espaceurs épais sont nécessaires sur les transistors HV pour assurer leur tenue en tension. En revanche, les transistors NVM n'ont pas besoin d'espaceurs aussi épais que les transistors HV. De tels espaceurs épais augmentent l'encombrement des transistors NVM et réduisent la densité des zones de mémoire non volatile du circuit intégré.

Un autre inconvénient de ce procédé est qu'il prévoit une étape d'oxydation thermique afin de remplacer par de l'oxyde thermique 29 les portions de couches isolantes 17 et éventuellement 19 qui sont surgravées sous les flancs de l'électrode 25 lors de l'étape décrite en relation avec la figure 1D. Cette oxydation thermique permet d'obtenir une isolation satisfaisante entre les deux électrodes 13 et 25 du condensateur CAPA, ce qui ne serait pas le cas si ces portions surgravées étaient remplacées par de l'oxyde de silicium déposé de manière conforme, par exemple par CVD ("Chemical Vapor Déposition" - dépôt chimique en phase vapeur), dont les propriétés isolantes sont moins bonnes que celles de l'oxyde de silicium thermique.

Il serait donc souhaitable de disposer d'un procédé de fabrication d'un circuit intégré palliant certains au moins des inconvénients du procédé décrit en relation avec les figures 1A à 1G.

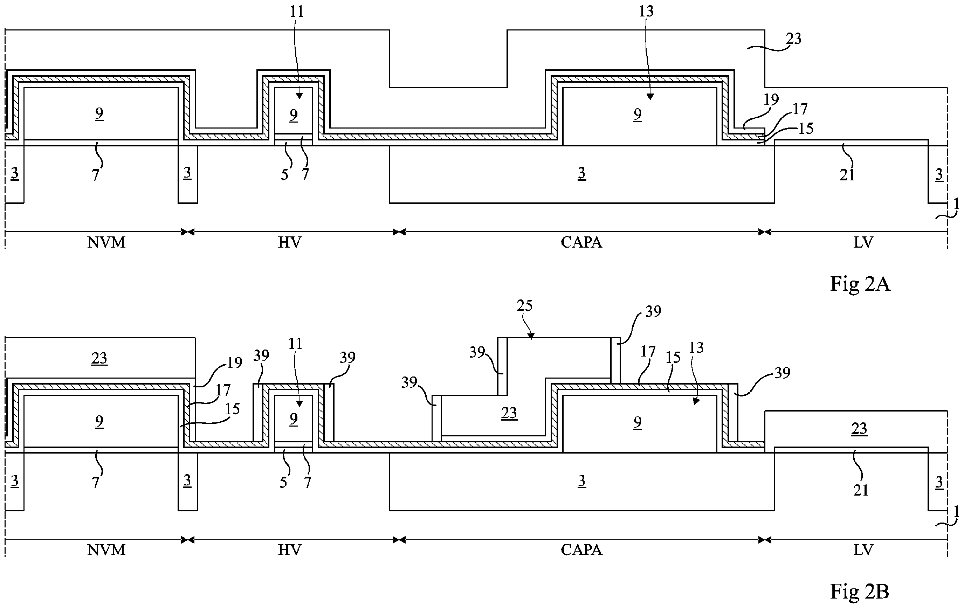

Les figures 2A à 2F sont des vues en coupe schématiques représentant une structure à des étapes successives d'un mode de réalisation d'un procédé de fabrication.

La figure 2A est identique à la figure 1C et représente la structure obtenue après avoir effectué les étapes décrites en relation avec les figures 1A à 1C.

La figure 2B représente la structure de la figure 2A après délimitation de la deuxième électrode 25 du condensateur CAPA, suivie de la formation d'espaceurs 39 en oxyde de silicium. Pour cela, comme cela a été décrit en relation avec la figure 1D, à l'emplacement du condensateur CAPA, la couche de silicium polycristallin 23 est retirée par gravure en laissant en place une portion de cette couche 23 correspondant à l'électrode 25, cette dernière reposant au moins en partie sur l'électrode 13. Lors de cette gravure, la couche 23 est également retirée à l'emplacement du transistor HV. La gravure de la couche de silicium polycristallin 23 se poursuit par la gravure de la couche d'oxyde de silicium 19 qui est arrêtée sur la couche de nitrure 17. Une couche d'oxyde de silicium 39 est ensuite déposée de manière conforme, au moins aux emplacements du condensateur CAPA et du transistor HV. L'oxyde de silicium 39 est gravé par gravure anisotrope pour former des espaceurs en oxyde de silicium 39 bordant latéralement les électrodes 13 et 25 du condensateur CAPA et l'empilement de grille 11 du transistor HV. A titre d'exemple, l'épaisseur des espaceurs 39 est comprise entre 2 et 25 nm, par exemple 15 nm.

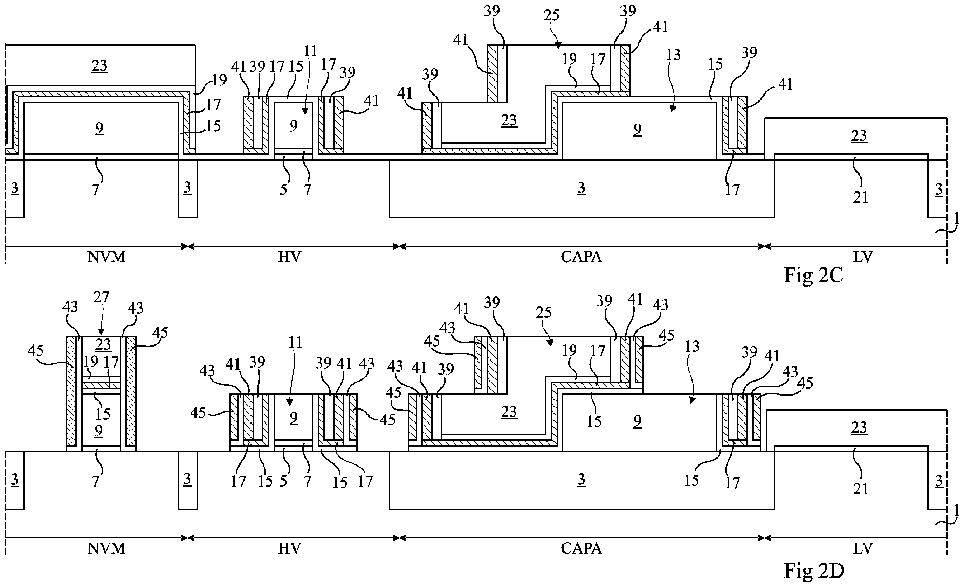

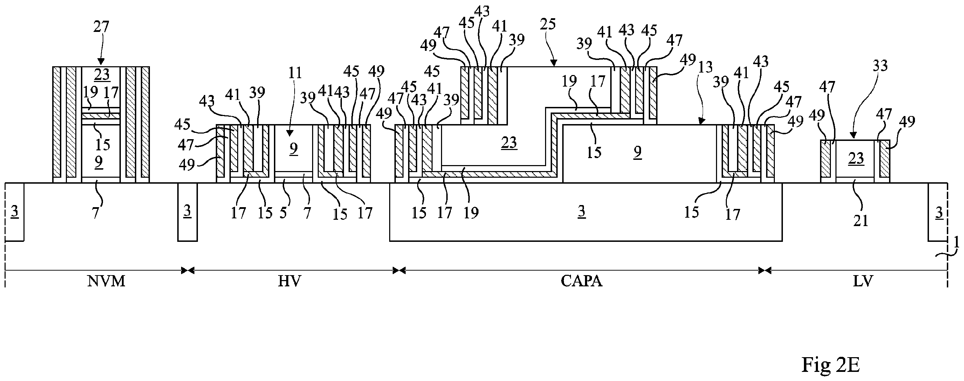

Pour simplifier les figures, les espaceurs 39 qui se forment contre les parois verticales des régions de silicium 23 des composants NVM et LV ne sont pas représentés car, comme on le verra ci-après, ils sont éliminés à une étape ultérieure (figures 2D et 2E).

La figure 2C représente la structure de la figure 2B après la formation d'espaceurs en nitrure de silicium 41. Pour cela, une couche de nitrure de silicium 41 est déposée de manière conforme, au moins aux emplacements du condensateur CAPA et des transistors NVM et HV. Le nitrure de silicium 41 est ensuite gravé par gravure anisotrope pour former des espaceurs en nitrure de silicium 41 bordant latéralement les espaceurs en oxyde de silicium 39 des transistors MOS HV et NVM et des électrodes 13 et 25 du condensateur CAPA. Lors de la gravure du nitrure de silicium 41, des portions de la couche de nitrure de silicium 17 se retrouvent exposées et sont retirées elles aussi. A titre d'exemple, l'épaisseur des espaceurs 41 est comprise entre 10 et 100 nm, par exemple 50 nm.

Pour simplifier les figures, les espaceurs 41 qui se forment contre les parois verticales des composants NVM et LV ne sont pas représentés car, comme on le verra ci-après, ils sont éliminés à une étape ultérieure (figures 2D et 2E).

Du fait que la gravure du nitrure de silicium 41 et 17 est une gravure anisotrope et, de plus, que les espaceurs 39 sont formés avant cette gravure, la couche de nitrure de silicium 17 n'est pas surgravée sous les flancs de l'électrode 25. Au contraire, la couche de nitrure 17 se prolonge de part et d'autre de l'électrode 25, au moins sous les espaceurs 39 et sous les espaceurs 41, la couche 15 se prolongeant elle-aussi au moins sous les espaceurs 39 et sous les espaceurs 41. L'isolation électrique entre les électrodes 13 et 25 du condensateur CAPA est alors assurée de manière satisfaisante par la succession de la couche d'oxyde 15, de la couche de nitrure 17 et de la couche d'oxyde 19 et, contrairement au procédé décrit en relation avec les figures 1A à 1G, il n'est pas nécessaire de prévoir une étape d'oxydation thermique.

La figure 2D représente la structure de la figure 2C après délimitation de l'empilement de grille 27 du transistor NVM suivie de la formation d'espaceurs en oxyde de silicium 43 et d'espaceurs en nitrure de silicium 45. L'empilement de grille 27 est formé de la même façon que cela a été décrit en relation avec la figure 1E. Après délimitation de l'empilement de grille 27, une couche d'oxyde de silicium 43 et une couche de nitrure de silicium 45 sont déposées successivement et de manière conforme, au moins aux emplacements du condensateur CAPA et des transistors NVM et HV. Le nitrure de silicium 45 et l'oxyde de silicium 43 sont ensuite gravés par gravure anisotrope pour former des espaceurs en oxyde de silicium 43 bordant latéralement les empilements de grille 11 et 27 des transistors HV et NVM, et les électrodes 13 et 25 du condensateur CAPA, et pour former des espaceurs en nitrure de silicium 45 bordant latéralement les espaceurs 43. A titre d'exemple, l'épaisseur des espaceurs 43 est comprise entre 4 et 18 nm, par exemple 12 nm. L'épaisseur des espaceurs 45 peut être comprise entre 3 et 10 nm, par exemple 5 nm.

Pour simplifier les figures, les espaceurs 43, 45 qui se forment contre les parois verticales des composants LV ne sont pas représentés car, comme on le verra ci-après, ils sont éliminés à l'étape suivante (figure 2E).

La figure 2E représente la structure de la figure 2D après délimitation de l'empilement de grille 33 du transistor LV suivie de la formation d'espaceurs en oxyde de silicium 47 et d'espaceurs en nitrure de silicium 49. L'empilement de grille 33 est formé de la même façon que cela a été décrit en relation avec la figure 1G. Après délimitation de l'empilement de grille 33, une couche d'oxyde de silicium 47 et une couche de nitrure de silicium 49 sont déposées successivement et de manière conforme sur toute la structure. Le nitrure de silicium 49 et l'oxyde de silicium 47 sont ensuite gravés par gravure anisotrope pour former des espaceurs en oxyde de silicium 47 et des espaceurs en nitrure de silicium 49. Plus particulièrement, les espaceurs 47 bordent latéralement les empilements de grille 11, 27 et 33 des transistors HV, NVM et LV, et les électrodes 13 et 25 du condensateur CAPA, et sont eux-mêmes bordés par les espaceurs en nitrure de silicium 49. A titre d'exemple, l'épaisseur des espaceurs 47 est comprise entre 1 et 8 nm, par exemple 5 nm. L'épaisseur des espaceurs 49 peut être comprise entre 10 et 40 nm, par exemple 25 nm.

On obtient ainsi un circuit intégré comprenant un condensateur CAPA et des transistors de différents types, à savoir des transistors NVM, HV et LV. Dans ce circuit, les espaceurs 47 et 49 bordant les empilements de grille 33 des transistors LV bordent également les empilements de grille 11 et 27 des transistors HV et NVM et les électrodes 13 et 25 du condensateur CAPA, les espaceurs 43 et 45 bordant les empilements de grille 27 des transistors NVM bordent également les empilements de grille 11 des transistors HV et les électrodes 13 et 25 du condensateur CAPA, et les espaceurs 39 et 41 ne bordent que les empilements 11 de grille des transistors HV et les électrodes 13 et 25 du condensateur CAPA. Ainsi, l'ensemble des espaceurs bordant les empilements de grille des transistors NVM est au moins aussi épais que celui bordant les empilements de grille des transistors HV, ce qui permet de former des transistors NVM moins larges, et donc des zones de mémoires NVM plus denses. En outre, l'ensemble des espaceurs bordant les empilements de grille des transistors LV est lui-même moins épais que celui bordant les empilements de grille des transistors NVM, puisque ces transistors ne sont pas destinés à être soumis à de hautes tensions, ce qui permet d'avoir des zones logiques (LV) de densité optimale.

Comme cela a déjà été souligné en relation avec la figure 2C et contrairement au procédé décrit en relation avec les figures 1A à 1G, le procédé décrit en relation avec les figures 2A à 2E permet d'éviter de recourir à une étape d'oxydation thermique pour isoler électriquement les électrodes 13 et 25 l'une de l'autre, l'isolation électrique entre ces électrodes étant réalisée de manière satisfaisante par l'empilement des couches 15, 17 et 19.

A titre d'exemple, les transistors NVM sont destinés à fonctionner à des tensions comprises entre 2 et 5 V. Les transistors HV sont par exemple destinés à fonctionner à des tensions comprises entre 6 et 12 V. Les transistors LV sont par exemple destinés à fonctionner à des tensions comprises entre 1 et 4 V. Le condensateur CAPA est destiné à fournir, entre ses deux électrodes 13 et 25, une différence de tension comprise entre 4 et 8 V.

Des modes de réalisation particuliers ont été décrits. Diverses variantes et modifications apparaîtront à l'homme de l'art. En particulier, bien que les étapes de dopage pour former les régions de drain, de source et de canal des transistors MOS NVM, HV et LV n'aient pas été décrites, l'homme de métier saura intégrer ces étapes dans le procédé décrit précédemment.

Le condensateur CAPA décrit ci-dessus comprend deux électrodes 25 et 13 reposant sur une structure isolante 3. Ces électrodes peuvent également reposer sur une couche dopée d'un premier type de conductivité formée dans une région de la couche semiconductrice 1 dopée du deuxième type de conductivité. Dans ce cas, l'électrode 25 du condensateur CAPA et la région dopée du deuxième type de conductivité peuvent être connectées électriquement.

Bien que dans les figures illustrant le procédé de fabrication décrit précédemment un seul transistor de chacun des types HV, NVM et LV et un seul condensateur aient été représentés, on comprendra que plusieurs transistors de chaque type et/ou plusieurs condensateurs CAPA peuvent être formés simultanément lors de la mise en oeuvre de ce procédé.

Les matériaux et les épaisseurs indiqués précédemment, à titre d'exemple pourront être adaptés par l'homme de métier. Par exemple, bien que l'on ait décrit des couches d'isolant de grille 5, 7 et 21 en oxyde de silicium, chacune de ces couches peut être en un autre matériau isolant couramment utilisé pour réaliser des isolants de grille, par exemple en un matériau dit "high k" dont la constante diélectrique est plus élevée que celle de l'oxyde de silicium. La couche semiconductrice peut être en un autre matériau semiconducteur que le silicium, par exemple en silicium-germanium. En outre, cette couche semiconductrice peut correspondre à une couche semiconductrice d'une structure de type SOI ("Semiconductor On Insulator" - semiconducteur sur isolant), c'est-à-dire une couche semiconductrice reposant sur une couche isolante reposant elle-même sur un substrat.

L'ordre et le nombre des étapes du procédé décrit ci-dessus peuvent être modifiés, à condition de respecter l'ordre défini dans la revendication 1. Par exemple, pour former les isolants de grille des transistors HV et NVM, on peut prévoir de ne former la couche 5 qu'aux seuls emplacements des transistors NVM, puis la couche 7 aux seuls emplacements des transistors HV en utilisant des couches de masquages adaptées.

L'homme de métier peut adapter les étapes ultérieures aux étapes des figures 2A et 2B tout en conservant les avantages du procédé décrit précédemment, à savoir que l'isolation entre les électrodes 13 et 25 du condensateur est réalisée par les couches 15, 17 et 19, et que les espaceurs des transistors réalisés ultérieurement aux étapes des figures 2A et 2B bordent l'empilement de grille du transistor HV et les électrodes 13 et 25 du condensateur CAPA. Ainsi, en plus du transistor HV et du condensateur CAPA, l'homme de métier peut prévoir de former des transistors autres que des transistors NVM et/ou LV. L'homme de métier peut également prévoir de fabriquer un circuit intégré ne comportant que des transistors HV et un condensateur CAPA.

## Revendications

1. Procédé de fabrication d'un circuit intégré comprenant au moins un transistor MOS haute tension, HV, et au moins un condensateur, CAPA, le procédé comprenant les étapes successives suivantes :
a) former, sur une couche semiconductrice (1), une première couche isolante (5) à l'emplacement du transistor HV ;
b) déposer une première couche de silicium polycristallin (9) ;
c) former un empilement de grille (11) du transistor HV et une première électrode (13) du condensateur CAPA en gravant la première couche de silicium polycristallin ;
d) former successivement une première couche d'oxyde de silicium (15), une couche de nitrure de silicium (17) et une deuxième couche d'oxyde de silicium (19) ;
e) déposer une deuxième couche de silicium polycristallin (23) ;
f) former une deuxième électrode (25) du condensateur CAPA reposant au moins en partie sur la première électrode (13) en gravant la deuxième couche de silicium polycristallin, et retirer les portions exposées de la deuxième couche d'oxyde (19) en laissant en place la couche de nitrure de silicium (17) et la première couche d'oxyde de silicium (15) ;
g) former, sur la couche de nitrure de silicium (17), des premiers espaceurs en oxyde de silicium (39) bordant latéralement l'empilement de grille (11) du transistor HV, les première et deuxième électrodes et une portion de la deuxième couche d'oxyde (19) laissée en place sous la deuxième électrode (25) ; et
h) former, sur la couche de nitrure de silicium (17), des deuxièmes espaceurs en nitrure de silicium (41) bordant latéralement les premiers espaceurs (39).

2. Procédé de fabrication selon la revendication 1, dans lequel le circuit intégré comprend, en outre, au moins un transistor MOS à grille flottante, NVM, le procédé comprenant, en outre, à l'emplacement du transistor NVM, les étapes suivantes :
a1) à l'étape a), former une deuxième couche isolante (7) sur la couche semiconductrice (1) ;
c1) à l'étape c), laisser en place la première couche de silicium polycristallin (9) ;
f1) à l'étape f), laisser en place la deuxième couche de silicium polycristallin (23) ;
i) après l'étape h), former un empilement de grille (27) du transistor NVM en gravant la deuxième couche de silicium polycristallin, la deuxième couche d'oxyde (19), la couche de nitrure de silicium (17), la première couche d'oxyde (15) et la première couche de silicium polycristallin ; et
j) sur l'ensemble du circuit intégré, former des troisièmes espaceurs (43, 45) bordant latéralement l'empilement de grille (27) du transistor NVM et les deuxièmes espaceurs (41).

3. Procédé de fabrication selon la revendication 2, dans lequel le circuit intégré comprend, en outre, au moins un transistor MOS basse tension, LV, le procédé comprenant, en outre, à l'emplacement du transistor LV, les étapes suivantes :
c2) à l'étape c), retirer la première couche de silicium polycristallin (9) ;
d2) à l'étape d), retirer la deuxième couche d'oxyde (19), la couche de nitrure (17) et la première couche d'oxyde (15) ;
e2) à l'étape e), former, sur la couche semiconductrice (1) et préalablement à la formation de la deuxième couche de silicium polycristallin (23), une troisième couche isolante (21) ;
f2) à l'étape f), laisser en place la deuxième couche de silicium polycristallin (23) ;
k) après l'étape j), former un empilement de grille (33) du transistor LV en gravant la deuxième couche de silicium polycristallin (23) ; et
l) sur l'ensemble du circuit intégré, former des quatrièmes espaceurs (47, 49) bordant latéralement l'empilement de grille (33) du transistor LV et les troisièmes espaceurs (45).

4. Circuit intégré comprenant au moins un transistor MOS haute tension, HV, et au moins un condensateur, CAPA, dans lequel :
l'empilement de grille (11) du transistor HV comporte une première couche isolante (5, 7) reposant sur une couche semiconductrice (1) et revêtue d'un premier silicium polycristallin (9) ;
le condensateur CAPA comporte une première électrode (13) en le premier silicium polycristallin reposant sur la couche semiconductrice, et une deuxième électrode (25) en un deuxième silicium polycristallin (23) reposant au moins en partie sur la première électrode, une première couche d'oxyde de silicium (15) revêtue d'une couche de nitrure de silicium (17) elle-même revêtue d'une deuxième couche d'oxyde de silicium (19) séparant la deuxième électrode de la couche semiconductrice et de la première électrode ;
des premiers espaceurs en oxyde de silicium (39) bordent latéralement la première électrode (13), l'empilement de grille (11) du transistor HV, la deuxième électrode (25) et une portion de la deuxième couche d'oxyde (19) s'étendant sous la deuxième électrode (25) ; et
des deuxièmes espaceurs en nitrure de silicium (41) bordent les premiers espaceurs (39), la première couche d'oxyde (15) et la couche de nitrure (17) s'étendant de part et d'autre de la deuxième électrode (25) sous les premiers (39) et deuxièmes (41) espaceurs bordant la deuxième électrode (25), la première couche d'oxyde (15) et la couche de nitrure (17) s'étendant également entre le premier espaceur (39) bordant l'empilement de grille (11) du transistor HV et l'empilement de grille (11) du transistor HV, et sous les premier et deuxième espaceurs bordant l'empilement de grille du transistor HV, la première couche d'oxyde (15) et la couche de nitrure (17) s'étendant en outre entre la première électrode (13) et le premier (39) espaceur bordant la première électrode (13), et sous les premier (39) et deuxième (41) espaceurs bordant la première électrode (13).

5. Circuit intégré selon la revendication 4, comprenant, en outre, au moins un transistor MOS à grille flottante, NVM, dans lequel :
l'empilement de grille (27) du transistor NVM comporte une deuxième couche isolante (7) reposant sur la couche semiconductrice (1) et revêtue successivement du premier silicium polycristallin (9), de la première couche d'oxyde (15), de la couche de nitrure (17), de la deuxième couche d'oxyde (19) et du deuxième silicium polycristallin (23) ; et
des troisièmes espaceurs (43, 45) bordent latéralement l'empilement de grille (27) du transistor NVM et les deuxièmes espaceurs (41).

6. Circuit intégré selon la revendication 5, comprenant, en outre, au moins un transistor MOS basse tension, LV, dans lequel :
l'empilement de grille (33) du transistor LV comporte une troisième couche isolante (21) reposant sur la couche semiconductrice (1) et revêtue du deuxième silicium polycristallin (23) ; et
des quatrièmes espaceurs (47, 49) bordent latéralement l'empilement de grille (33) du transistor LV et les troisièmes espaceurs (45).

## Patentansprüche

1. Verfahren zur Herstellung einer integrierten Schaltung mit mindestens einem Hochspannungs-MOS-Transistor, HV, und wenigstens einem Kondensator, CAPA, wobei das Verfahren die aufeinanderfolgenden Schritte aufweist:
a) Ausbilden einer ersten Isolierschicht (5) auf einer Halbleiterschicht (1) an der Stelle des HV-Transistors;
b) Abscheiden einer ersten Polysiliziumschicht (9);
c) Ausbilden eines Gate-Stapels (11) des HV-Transistors und einer ersten Elektrode (13) des Kondensators CAPA durch Ätzen der ersten Polysiliziumschicht;
d) aufeinanderfolgendes Ausbilden einer ersten Siliziumoxidschicht (15), einer Siliziumnitridschicht (17) und einer zweiten Siliziumoxidschicht (19);
e) Abscheiden einer zweiten Polysiliziumschicht (23);
f) Ausbilden einer zweiten Elektrode (25) des Kondensators CAPA, die wenigstens teilweise auf der ersten Elektrode (13) ruht, durch Ätzen der zweiten Polysiliziumschicht, und Entfernen der freiliegenden Abschnitte der zweiten Oxidschicht (19), durch belassen der Siliziumnitridschicht (17) und der ersten Siliziumoxidschicht (15) an Ort und Stelle;
g) Ausbilden, auf der Siliziumnitridschicht (17), von ersten Siliziumoxid-Abstandshaltern (39), die seitlich an den Gate-Stapel (11) des HV-Transistors, die erste und zweite Elektrode und einen Teil der zweiten Oxidschicht (19), die unter der zweiten Elektrode (25) an Ort und Stelle belassen wurde, angrenzen; und
h) Ausbilden, auf der Siliziumnitridschicht (17), von zweiten Siliziumnitrid-Abstandshaltern (41), die seitlich an die ersten Abstandshalter (39) angrenzen.

2. Herstellungsverfahren nach Anspruch 1, wobei die integrierte Schaltung ferner wenigstens einen Floating-Gate-MOS-Transistor, NVM, aufweist, wobei das Verfahren ferner an der Stelle des NVM-Transistors die folgenden Schritte aufweist:
a1) in Schritt a), Ausbilden einer zweiten Isolierschicht (7) auf der Halbleiterschicht (1);
c1) in Schritt c), Belassen der ersten Polysiliziumschicht (9) an Ort und Stelle;
f1) in Schritt f) Belassen der zweiten Polysiliziumschicht (23) an Ort und Stelle;
i) nach Schritt h), Ausbilden eines Gate-Stapels (27) des NVM-Transistors durch Ätzen der zweiten Polysiliziumschicht, der zweiten Oxidschicht (19), der Siliziumnitridschicht (17), der ersten Oxidschicht (15) und der ersten Polysiliziumschicht; und
j) Ausbilden, über der gesamten integrierten Schaltung, dritter Abstandshalter (43, 45), die seitlich an den Gate-Stapel (27) des NVM-Transistors und die zweiten Abstandshalter (41) angrenzen.

3. Herstellungsverfahren nach Anspruch 2, wobei die integrierte Schaltung ferner wenigstens einen Niederspannungs-MOS-Transistor, LV, aufweist, wobei das Verfahren ferner an der Stelle des LV-Transistors die folgenden Schritte aufweist:
c2) in Schritt c), Entfernen der ersten Polysiliziumschicht (9);
d2) in Schritt d), Entfernen der zweiten Oxidschicht (19), der Nitridschicht (17) und der ersten Oxidschicht (15);
e2) in Schritt e), Ausbilden einer dritten Isolierschicht (21) auf der Halbleiterschicht (1) und zwar vor dem Ausbilden der zweiten Polysiliziumschicht (23);
f2) in Schritt f), Belassen der zweiten Polysiliziumschicht (23) an Ort und Stelle;
k) nach Schritt j), Ausbilden eines Gate-Stapels (33) des LV-Transistors durch Ätzen der zweiten Polysiliziumschicht (23); und
l) Ausbilden, über die gesamte integrierte Schaltung, vierter Abstandshalter (47, 49) die seitlich an den Gate-Stapel (33) des LV-Transistors und die dritten Abstandshalter (45) angrenzen.

4. Integrierte Schaltung mit wenigstens einem Hochspannungs-MOS-Transistor, HV, und wenigstens einem Kondensator, CAPA, wobei:
der Gate-Stapel (11) des HV-Transistors eine erste Isolierschicht (5, 7) aufweist, die auf einer Halbleiterschicht (1) ruht und mit einem ersten Polysilizium (9) beschichtet ist;
der Kondensator CAPA Folgendes aufweist: eine erste Elektrode (13) hergestellt aus dem ersten Polysilizium das auf der Halbleiterschicht ruht, und eine zweite Elektrode (25) hergestellt aus einem zweiten Polysilizium (23), das wenigstens teilweise auf der ersten Elektrode ruht, wobei eine erste Siliziumoxidschicht (15), die mit einer Siliziumnitridschicht (17) beschichtet ist, die ihrerseits mit einer zweiten Siliziumoxidschicht (19) beschichtet ist, die zweite Elektrode von der Halbleiterschicht und der ersten Elektrode trennt;
erste Siliziumoxid-Abstandshalter (39) seitlich angrenzen an die erste Elektrode (13), den Gate-Stapel (11) des HV-Transistors, die zweite Elektrode (25) und einen Teil der zweiten Oxidschicht (19), der sich unter der zweiten Elektrode (25) erstreckt; und
zweite Siliziumnitrid-Abstandshalter (41) angrenzen an die ersten Abstandshalter (39), wobei sich die erste Oxidschicht (15) und die Nitridschicht (17) auf beiden Seiten der zweiten Elektrode (25) unter den ersten (39) und zweiten (41) Abstandshaltern erstrecken, die an die zweite Elektrode (25) angrenzen, wobei sich die erste Oxidschicht (15) und die Nitridschicht (17) auch zwischen dem ersten Abstandshalter (39), der an den Gate-Stapel (11) des HV-Transistors angrenzt, und dem Gate-Stapel (11) des HV-Transistors erstrecken, und unter den ersten und zweiten Abstandshalter, die an den Gate-Stapel des HV-Transistors angrenzen, wobei sich die erste Oxidschicht (15) und die Nitridschicht (17) weiter zwischen der ersten Elektrode (13) und dem ersten Abstandshalter (39), der an die erste Elektrode (13) angrenzt, und unter den ersten (39) und zweiten (41) Abstandshaltern, die an die erste Elektrode (13) angrenzen, erstrecken.

5. Integrierte Schaltung nach Anspruch 4, die weiterhin wenigstens einen Floating-Gate-MOS-Transistor, NVM, aufweist, wobei:
der Gate-Stapel (27) des NVM-Transistors eine zweite Isolierschicht (7) aufweist, die auf der Halbleiterschicht (1) ruht und aufeinanderfolgend beschichtet ist mit dem ersten Polysilizium (9), mit der ersten Oxidschicht (15), mit der Nitridschicht (17), mit der zweiten Oxidschicht (19) und mit dem zweiten Polysilizium (23); und
dritte Abstandshalter (43, 45) seitlich angrenzen an den Gate-Stapel (27) des NVM-Transistors und die zweiten Abstandshalter (41).

6. Integrierte Schaltung nach Anspruch 5, die ferner wenigstens einen Niederspannungs-MOS-Transistor, LV, aufweist, wobei:
der Gate-Stapel (33) des LV-Transistors eine dritte Isolierschicht (21) aufweist, die auf der Halbleiterschicht (1) ruht und mit dem zweiten Polysilizium (23) beschichtet ist; und
vierte Abstandshalter (47, 49) seitlich angrenzen an den Gate-Stapel (33) des LV-Transistors und die dritten Abstandshalter (45).

## Claims

1. A method of manufacturing an integrated circuit comprising at least one high-voltage MOS transistor, HV, and at least one capacitor, CAPA, the method comprising the successive steps of:
a) forming, on a semiconductor layer (1), a first insulating layer (5) at the location of the HV transistor;
b) depositing a first polysilicon layer (9);
c) forming a gate stack (11) of the HV transistor and a first electrode (13) of capacitor CAPA by etching the first polysilicon layer;
d) successively forming a first silicon oxide layer (15), a silicon nitride layer (17) and a second silicon oxide layer (19);
e) depositing a second polysilicon layer (23);
f) forming a second electrode (25) of capacitor CAPA at least partly resting on the first electrode (13) by etching the second polysilicon layer, and removing the exposed portions of the second oxide layer (19) by leaving in place the silicon nitride layer (17) and the first silicon oxide layer (15);
g) forming, on the silicon nitride layer (17), first silicon oxide spacers (39) laterally bordering the gate stack (11) of the HV transistor, the first and second electrodes and a portion of the second oxide layer (19) left in place under the second electrode (25); and
h) forming, on the silicon nitride layer (17), second silicon nitride spacers (41) laterally bordering the first spacers (39) .

2. The manufacturing method of claim 1, wherein the integrated circuit further comprises at least one floating-gate MOS transistor, NVM, the method further comprising, at the location of the NVM transistor, the steps of:
a1) at step a), forming a second insulating layer (7) on the semiconductor layer (1);
c1) at step c), leaving in place the first polysilicon layer (9);
f1) at step f), leaving in place the second polysilicon layer (23);
i) after step h), forming a gate stack (27) of the NVM transistor by etching the second polysilicon layer, the second oxide layer (19), the silicon nitride layer (17), the first oxide layer (15) and the first polysilicon layer; and
j) over the entire integrated circuit, forming third spacers (43, 45) laterally bordering the gate stack (27) of the NVM transistor and the second spacers (41).

3. The manufacturing method of claim 2, wherein the integrated circuit further comprises at least one low-voltage MOS transistor, LV, the method further comprising, at the location of the LV transistor, the steps of:
c2) at step c), removing the first polysilicon layer (9) ;
d2) at step d), removing the second oxide layer (19), the nitride layer (17) and the first oxide layer (15);
e2) at step e), forming, on the semiconductor layer (1) and prior to the forming of the second polysilicon layer (23), a third insulating layer (21);
f2) at step f), leaving in place the second polysilicon layer (23);
k) after step j), forming a gate stack (33) of the LV transistor by etching the second polysilicon layer (23); and
l) over the entire integrated circuit, forming fourth spacers (47, 49) laterally bordering the gate stack (33) of the LV transistor and the third spacers (45).

4. An integrated circuit comprising at least one high-voltage MOS transistor, HV, and at least one capacitor, CAPA, wherein:
the gate stack (11) of the HV transistor comprises a first insulating layer (5, 7) resting on a semiconductor layer (1) and coated with a first polysilicon (9);
capacitor CAPA comprises a first electrode (13) made of the first polysilicon resting on the semiconductor layer, and a second electrode (25) made of a second polysilicon (23) at least partly resting on the first electrode, a first silicon oxide layer (15) coated with a silicon nitride layer (17), itself coated with a second silicon oxide layer (19) separating the second electrode from the semiconductor layer and from the first electrode;
first silicon oxide spacers (39) laterally border the first electrode (13), the gate stack (11) of the HV transistor, the second electrode (25) and a portion of the second oxide layer (19) extending under the second electrode (25); and
second silicon nitride spacers (41) border the first spacers (39), the first oxide layer (15) and the nitride layer (17) extending on either side of the second electrode (25) under the first (39) and second (41) spacers bordering the second electrode (25), the first oxide layer (15) and the nitride layer (17) also extending between the first spacer (39) bordering the gate stack (11) of the HV transistor and the gate stack (11) of the HV transistor, and under the first and second spacers bordering the gate stack of the HV transistor, the first oxide layer (15) et the nitride layer (17) further extending between the first electrode (13) and the first spacer (39) bordering the first electrode (13), and under the first (39) and second (41) spacers bordering the first electrode (13).

5. The integrated circuit of claim 4, further comprising at least one floating-gate MOS transistor, NVM, wherein:
the gate stack (27) of the NVM transistor comprises a second insulating layer (7) resting on the semiconductor layer (1) and successively coated with the first polysilicon (9), with the first oxide layer (15), with the nitride layer (17), with the second oxide layer (19) and with the second polysilicon (23); and
third spacers (43, 45) laterally border the gate stack (27) of the NVM transistor and the second spacers (41).

6. The integrated circuit of claim 5, further comprising at least one low-voltage MOS transistor, LV, wherein:
the gate stack (33) of the LV transistor comprises a third insulating layer (21) resting on the semiconductor layer (1) and coated with the second polysilicon (23); and
fourth spacers (47, 49) laterally border the gate stack (33) of the LV transistor and the third spacers (45).
